# EUROPEAN PATENT APPLICATION

(11) **EP 4 628 625 A2**
(43) Date of publication of application: **08.10.2025**
(21) Application number: 25153090.3
(22) Date of filing: 21.01.2025
(51) Int. Cl.: C23C 16/455, H01L 21/02

(54) **SUBSTRATE PROCESSING APPARATUS AND METHOD OF MANUFACTURING SEMICONDUCTOR DEVICE**

(30) Priority: 26.03.2024 JP 2024050328
(71) Applicant: Kokusai Electric Corporation, Tokyo 101-0045 (JP)
(72) Inventor: NISHIMOTO, Hideyuki, Toyama-shi, Toyama 939-2393 (JP); HIRANO, Atsushi, Toyama-shi, Toyama 939-2393 (JP); KASAMATSU, Kenta, Toyama-shi, Toyama 939-2393 (JP)
(74) Representative: Bardehle Pagenberg Partnerschaft mbB Patentanwälte Rechtsanwälte

(57) **Abstract**

There is provided a technique that includes a process chamber (201) including an exhaust hole (233) facing a side of a plurality of accommodated substrates (200); a first nozzle (249a, 249b) installed at a position facing the exhaust hole (233) and configured to supply a process gas into the process chamber (201); and a second nozzle (249c, 249d) configured to supply an inert gas into the process chamber (201), and formed with a plurality of first ejection holes (250c1, 250d1) corresponding to each of the substrates (200) and opened toward an upstream of a gas flow flowing from the first nozzle (249a, 249b) to the exhaust hole (233) and one or more second ejection holes (250c2, 250d2) corresponding to some of the substrates (200) and opened toward a downstream of the gas flow, wherein the first and second nozzles (249a, 249b, 249c, 249d) are configured to mix the inert gas, supplied from at least one of the first and second ejection holes (250c2, 250d2), and the process gas at peripheral edges of the substrates (200).

## Description

### CROSS-REFERENCE TO RELATED APPLICATION

This application is based upon and claims the benefit of priority from Japanese Patent Application No. 2024-050328, filed on March 26, 2024, the entire contents of which are incorporated herein by reference.

### TECHNICAL FIELD

The present disclosure relates to a substrate processing apparatus and a method of manufacturing a semiconductor device.

### BACKGROUND

In the related art, as a process of manufacturing a semiconductor device, a substrate processing process of supplying a flow rate-controlled process gas (e.g., a precursor gas, a reaction gas, etc.) to a substrate to form a film on the substrate may be carried out. At this time, for some reasons, the process gas may not be supplied evenly onto the substrate, making it difficult to evenly form the film on the substrate.

### SUMMARY

Some embodiments of the present disclosure provide a technique for supplying a process gas evenly onto a substrate.

According to embodiments of the present disclosure, there is provided a technique that includes a process chamber including an exhaust hole facing a side of a plurality of accommodated substrates; a first nozzle installed at a position facing the exhaust hole and configured to supply a process gas into the process chamber; and a second nozzle configured to supply an inert gas into the process chamber, and formed with a plurality of first ejection holes that correspond to each of the substrates and are opened toward an upstream of a gas flow flowing from the first nozzle to the exhaust hole and one or more second ejection holes that correspond to some of the substrates and are opened toward a downstream of the gas flow, wherein the first nozzle and the second nozzle are configured to mix the inert gas, which is supplied from at least one of the first and second ejection holes, and the process gas at peripheral edges of the substrates.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a substrate processing apparatus suitably used in embodiments of the present disclosure, in which a portion of a process furnace is shown in a vertical cross-sectional view.
FIG. 2 is a diagram showing a portion of the process furnace of the substrate processing apparatus suitably used in the embodiments of the present disclosure, in which the portion of the process furnace is shown in a cross-sectional view taken along line A-A in FIG. 1.
FIG. 3 is a schematic configuration diagram of a controller of the substrate processing apparatus suitably used in the embodiments of the present disclosure, in which a control system of the controller is shown in a block diagram.
FIG. 4 is a diagram showing a film-forming sequence of the substrate processing apparatus suitably used in the embodiments of the present disclosure.
FIG. 5 is a diagram for explaining disposition angles of a process nozzle and a counter nozzle of the substrate processing apparatus suitably used in the embodiments of the present disclosure.
FIG. 6A is a diagram for explaining formation angles of a first ejection hole and a second ejection hole of the counter nozzle of the present disclosure.
FIG. 6B is a diagram for explaining formation angles of a first ejection hole and a second ejection hole of the counter nozzle of the present disclosure.
FIG. 7A is a diagram for explaining a relationship between a dummy region/ a product region and the first ejection hole/ the second ejection hole in a process chamber of the substrate processing apparatus suitably used in the embodiments of the present disclosure.
FIG. 7B is a diagram for explaining gas ejection from the product region.
FIG. 7C is a diagram for explaining gas ejection from the dummy region.
FIG. 8A is a diagram for explaining a gas flow in the dummy region of the substrate processing apparatus suitably used in the embodiments of the present disclosure.
FIG. 8B is a diagram for explaining a gas flow in a dummy region of a substrate processing apparatus of Comparative Example 1.
FIG. 8C is a diagram for explaining a gas flow in a dummy region of a substrate processing apparatus of Comparative Example 2.
FIG. 9A is a diagram for explaining an angle between the first ejection hole and the second ejection hole in a second protruding portion of the substrate processing apparatus suitably used in the embodiments of the present disclosure.
FIG. 9B is a diagram for explaining an angle between the first ejection hole and the second ejection hole in a third protruding portion of the substrate processing apparatus suitably used in the embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

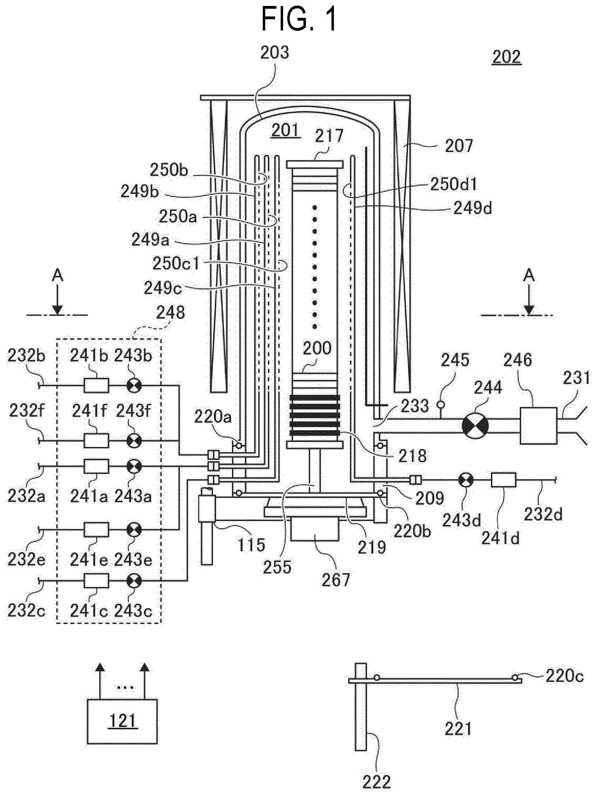

Embodiments of the present disclosure are described below with reference to FIGS. 1 to 9B. The drawings used in the following description are schematic, and the dimensional relationships, proportions, and the like of respective elements shown in the drawings do not always match those in reality. Further, the dimensional relationships, proportions, and the like of respective elements do not always match among multiple drawings.

### (1) Configuration of Substrate Processing Apparatus

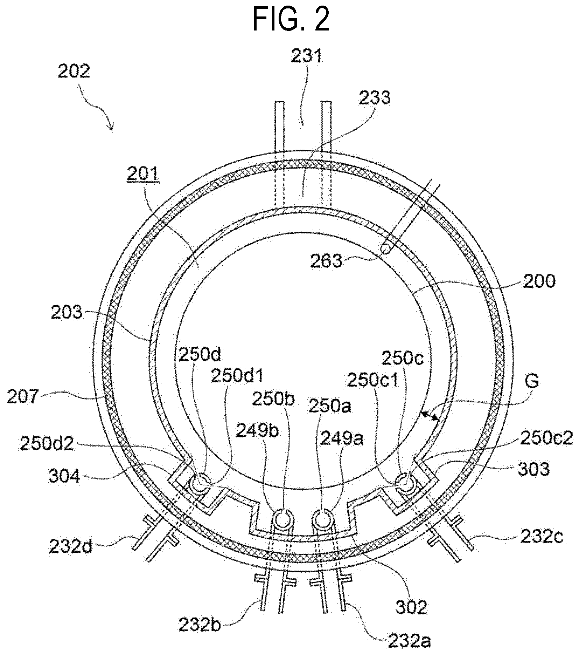

As shown in FIGS. 1 and 2, a substrate processing apparatus 202 includes a heater 207 as a heating means (a heating mechanism). The heater 207 is formed in a cylindrical shape and is supported by a support plate so as to be vertically installed. The heater 207 also functions as an activator (an exciter) that thermally activates (excites) a gas.

A reaction tube 203 as an inner tube is disposed inside the heater 207 to be concentric with the heater 207. The reaction tube 203 is made of, for example, a heat resistant material such as quartz (SiO₂) or silicon carbide (SiC), and is formed in a cylindrical shape with its upper end closed and its lower end opened. A manifold 209 is disposed below the reaction tube 203 to be concentric with the reaction tube 203. The manifold 209 is made of, for example, metal such as a nickel alloy, and is formed in a short cylindrical shape with both the upper end and lower end opened. An upper end of the manifold 209 engages with the lower end of the reaction tube 203 so as to support the reaction tube 203. An O-ring 220a serving as a seal is provided between the manifold 209 and the reaction tube 203. Similar to the heater 207, the reaction tube 203 is vertically installed. A process container (reaction container) mainly includes the reaction tube 203 and the manifold 209. A process chamber 201 is formed inside the process container. The process chamber 201 is configured to be capable of accommodating wafers 200 as substrates.

In the process chamber 201, nozzles 249a and 249b as first nozzles for supplying a film-forming gas (a process gas) and nozzles 249c and 249d as second nozzles for supplying an inert gas are provided so as to penetrate through a sidewall of the manifold 209. Gas supply pipes 232a to 232d are connected to the nozzles 249a to 249d, respectively.

The nozzles 249a and 249b are used as process gas nozzles for supplying the film-forming gas (the process gas) into the process chamber 201. In addition, the nozzles 249c and 249d are used as inert gas nozzles for supplying the inert gas into the process chamber 201. The nozzles 249c and 249d are used as counter nozzles for supplying the inert gas from a system separate from the film-forming gas. Two counter nozzles are disposed in the process chamber 201. The counter nozzles are respectively disposed at a predetermined distance from the process gas nozzles in a circumferential direction of the wafers 200.

On the gas supply pipes 232a to 232d, mass flow controllers (MFCs) 241a to 241d, which are flow-rate controllers (flow-rate control parts), and valves 243a to 243d, which are opening/closing valves, are respectively installed sequentially from an upstream of a gas flow. Gas supply pipes 232e and 232f for supplying the inert gas are connected to the gas supply pipes 232a and 232b at a downstream of the valves 243a and 243b, respectively. On the gas supply pipes 232e and 232f, MFCs 241e and 241f and valves 243e and 243f are respectively installed sequentially from an upstream of a gas flow.

The reaction tube 203 is formed with a first protruding portion 302 as a first nozzle chamber protruding outside from the process chamber 201 so as to accommodate the nozzles 249a and 249b, a second protruding portion 303 as a second nozzle chamber protruding outside from the process chamber 201 so as to accommodate the nozzle 249c, and a third protruding portion 304 as a second nozzle chamber protruding outside from the process chamber 201 so as to accommodate the nozzle 249d. The first protruding portion 302 may be divided into a plurality of portions so as to accommodate the nozzles 249a and 249b, respectively.

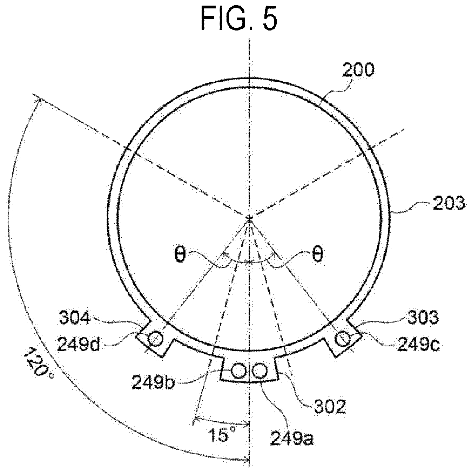

The first protruding portion 302 is formed at a position facing an exhaust hole 233. The second protruding portion 303 and the third protruding portion 304 are each formed at a position spaced by a predetermined distance from the first protruding portion 302 in a circumferential direction of the reaction tube 203. Herein, the predetermined distance is a distance of an arc within a range of 15 degrees or more to 120 degrees or less from the first protruding portion 302 in the circumferential direction of the reaction tube 203 (*see* FIG. 5). In other words, the predetermined distance is a distance of an arc where an angle θ between a line connecting a center of the first protruding portion 302 of the reaction tube 203 and a center of the wafer 200 and a line connecting each center of each of the second protruding portion 303 and the third protruding portion 304 and the center of the wafer 200 is within the range of 15 degrees or more to 120 degrees or less. That is, for the nozzle 249c and the nozzle 249d, the predetermined distance is a distance of an arc where an angle θ between a line connecting a center of the nozzles 249a and 249b and the center of the wafer 200 and a line connecting each center of each of the nozzles 249c and 249d and the center of the wafer 200 is within the range of 15 degrees or more to 120 degrees or less.

In an example shown in FIG. 2, the second protruding portion 303 and the third protruding portion 304 are each formed at a position 30 degrees away from the first protruding portion 302 in the circumferential direction of the reaction tube 203.

The first protruding portion 302 is configured such that an inside of the first protruding portion 302 constitutes a portion of the process chamber 201 and accommodates the nozzles 249a and 249b. The second protruding portion 303 is configured such that an inside of the second protruding portion 303 constitutes a portion of the process chamber 201 accommodates the nozzle 249c. The third protruding portion 304 is configured such that an inside of the third protruding portion 304 constitutes a portion of the process chamber 201 and accommodates the nozzle 249d.

The nozzles 249a and 249b are each installed in the first protruding portion 302 along an arrangement direction of the wafers 200 from a lower portion of the reaction tube 203 to an upper portion thereof. The nozzles 249a and 249b are disposed to be adjacent to each other in the first protruding portion 302. The nozzles 249a and 249b are disposed to face the exhaust hole 233, which is described later, with the centers of the wafers 200, loaded into the process chamber 201, interposed therebetween.

As shown in FIG. 2, the nozzles 249c and 249d are respectively installed in the second protruding portion 303 and the third protruding portion 304 along the arrangement direction of the wafers 200 from the lower portion of the reaction tube 203 to the upper portion thereof. As described above, the nozzles 249c and 249d are disposed at positions in the circumferential direction of the wafer 200 at the angle of 15 degrees or more to 120 degrees or less from the line connecting the center of the process gas nozzle (the nozzles 249a and 249b) and the center of the wafer.

If the angle is less than 15 degrees, an angle between an inert gas flow from first ejection holes 250c1 and 250d1 and a process gas flow from the nozzles 249a and 249b is shallow, such that the process gas flow may not be pushed sufficiently toward the center of the wafer 200 (the inert gas flow may become the same flow as the process gas). In addition, if the angle exceeds 120 degrees, a distance between the first ejection holes 250c1 and 250d1 and the nozzles 249a and 249b is large, such that an effect of dilution at an edge of the wafer 200 by the first ejection holes 250c1 and 250d1 may be reduced. In addition, the inert gas from second ejection holes 250c2 and 250d2 may flow directly into the exhaust hole 233, hindering smooth exhaust of the process gas, which may result in a pressure increase and an increase in film thickness at the edge of the wafer 200.

If the angle is 120 degrees or less, an influence of exhaust from the exhaust hole 233 on the second ejection holes 250c2 and 250d2, which is described later, is reduced, and an effect of counter by the first ejection holes 250c1 and 250d1 and the second ejection holes 250c2 and 250d2, which is described later, is exerted.

Note that the point of 90 degrees is where a flow passage area is largest in a horizontal direction in the process chamber 201, therefore, if the angle is 90 degrees or less, it is considered that the influence of the exhaust from the exhaust hole 233 is almost eliminated. Therefore, it is preferable that the nozzles 249c and 249d are positioned such that the angle θ between the line connecting the center of the process gas nozzle (the nozzles 249a and 249b) and the center of the wafer 200 and the line connecting the each center of each of the nozzles 249c and 249d and the center of the wafer 200 is 15 degrees or more and 90 degrees or less.

Further, it is preferable that the nozzle 249c and the nozzle 249d are disposed near both ends of the nozzles 249a and 249b. That is, it is preferable that the nozzle 249c and the nozzle 249d are positioned such that the angle θ between the line connecting the center of the process gas nozzle (the nozzles 249a and 249b) and the center of the wafer 200 and the line connecting the each center of each of the nozzles 249c and 249d and the center of the wafer 200 is 15 degrees or more and 45 degrees or less. This allows the effect of counter on the wafer 200 by the first ejection holes 250c1 and 250d1 and the second ejection holes 250c2 and 250d2, which is described later, to be exerted, making it possible to suppress a return flow of the process gas supplied from the process gas nozzle and directing a flow direction of the process gas toward the exhaust hole 233. Furthermore, it enables a smooth gas flow of the process gas over the wafer 200.

Moreover, the nozzles 249c and 249d are disposed in line symmetry with respect to a line connecting the center of the process gas nozzle and a center of the exhaust hole 233. In other words, among regions divided by the line connecting the center of the process gas nozzle and the center of the exhaust hole 233, the nozzle 249d is provided in a region opposite to a region where the nozzle 249c is installed. Herein, the center of the process gas nozzle is a center of the nozzle 249a, a center of the nozzle 249b, or a midpoint between the center of the nozzle 249a and the center of the nozzle 249b.

The nozzle 249a includes a plurality of gas supply holes 250a arranged in a line, and the nozzle 249b includes a plurality of gas supply holes 250b arranged in a line. Each of the gas supply holes 250a and 250b is configured to be capable of supplying a gas toward the center of wafer 200. The gas supply holes 250a and 250b are formed in plural so as to open toward the center of each wafer 200 from the lower portion of the reaction tube 203 to the upper portion thereof. That is, the gas supply holes 250a and 250b are opened so as to eject the gas toward the center of the wafer 200. The gas supplied from the gas supply holes 250a and 250b heads toward the exhaust hole 233 via the wafer 200.

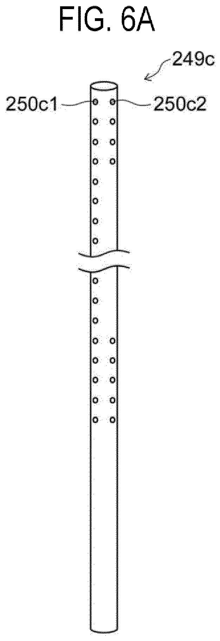

As shown in FIG. 6A, the nozzle 249c includes a plurality of first ejection holes 250c1 formed to be arranged in a line at positions respectively corresponding to the plurality of wafers 200. The nozzle 249c also includes a plurality of second ejection holes 250c2 formed to be arranged in a line at positions corresponding to some of the wafers 200 in an axial direction (the arrangement direction of the wafers 200).

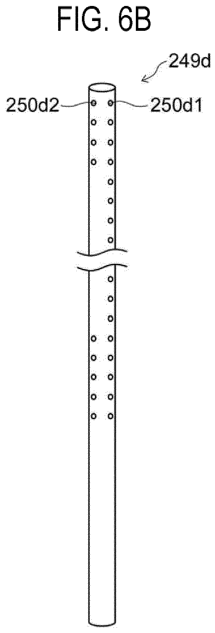

As shown in FIG. 6B, The nozzle 249d includes a plurality of first ejection holes 250d1 formed to be arranged in a line at positions respectively corresponding to the plurality of wafers 200. The nozzle 249d also includes a plurality of second ejection holes 250d2 formed to be arranged in a line at positions corresponding to some of the wafers 200 in the axial direction (the arrangement direction of the wafers 200).

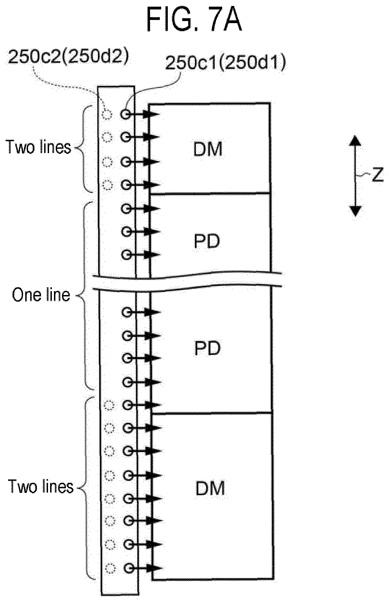

In this embodiment, as an example, as shown in FIG. 7A, dummy regions DM where dummy wafers 200 are disposed are formed at both ends (an uppermost side and a lowermost side) in the wafer 200 arrangement direction Z, and a product region PD where product wafers 200 are disposed is formed between the dummy regions DM. The first ejection holes 250c1 and 250d1 are formed at positions corresponding to the dummy regions DM and the product region PD, and the second ejection holes 250c2 and 250d2 are formed at positions corresponding to the dummy regions DM. In other words, the second ejection holes 250c2 and 250d2 are provided to correspond to one or more wafers 200 disposed at the uppermost side among the plurality of wafers 200 and one or more wafers 200 disposed at the lowermost side among the plurality of wafers 200. In addition, the second ejection holes 250c2 and 250d2 are disposed so as to sandwich the product wafers 200, among the plurality of wafers 200.

The first ejection holes 250c1 and 250d1 and the second ejection holes 250c2 and 250d2 are disposed at the same position (height) in the arrangement direction of the plurality of wafers 200. In addition, the first ejection holes 250c1 and 250d1 and the second ejection holes 250c2 and 250d2 are provided to correspond to the same wafer 200 in the arrangement direction of the plurality of wafers 200.

The first ejection holes 250c1 and 250d1 are opened toward an upstream of a gas flow flowing from the gas supply holes 250a and 250b toward the exhaust hole 233, that is, toward a direction of the nozzles 249a and 249b. In addition, the second ejection holes 250c2 and 250d2 are opened toward a downstream of the gas flow flowing from the gas supply holes 250a and 250b to the exhaust hole 233, that is, toward a direction of the exhaust hole 233. Gas flows from the gas supply holes 250a and 250b are designated GA and GB, a gas flow from the first ejection holes 250c1 and 250d1 is designated G1, and a gas flow from the second ejection holes 250c2 and 250d2 is designated G2.

Note that the upstream of the gas flow from the gas supply holes 250a and 250b to the exhaust hole 233 means an upstream half of a straight path from the gas supply holes 250a and 250b to the exhaust hole 233. In addition, the downstream of the gas flow from the gas supply holes 250a and 250b to the exhaust hole 233 means a downstream half of the straight path from the gas supply holes 250a and 250b to the exhaust hole 233.

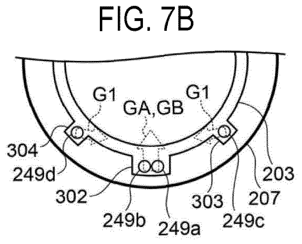

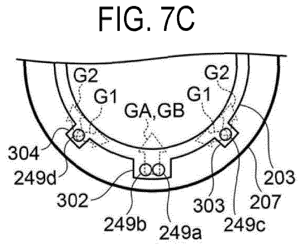

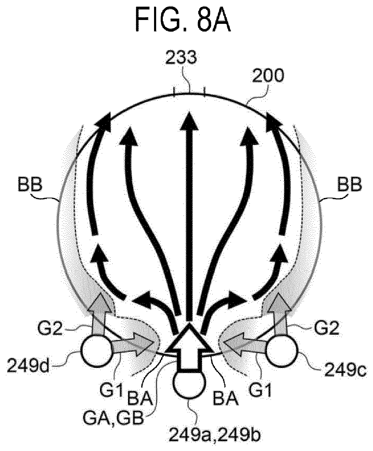

As shown in FIG. 7B, in the product region PD, the gas flow G1 from the first ejection holes 250c1 and 250d1 in the nozzles 249c and 249d is ejected toward the upstream into the gas flows GA and GB from the gas supply holes 250a and 250b along an inner wall of the process chamber 201. On the other hand, as shown in FIG. 7C, in the dummy regions DM, the gas flow G1 is ejected toward the upstream into the gas flows GA and GB, and the gas flow G2 from the second ejection holes 250c2 and 250d2 is ejected toward the downstream into the gas flows GA and GB. As a result, as shown in FIG. 8A, the gas flows GA and GB are pushed toward an inside of the wafer 200 by the gas flow G1, and then toward an outer periphery of the wafer 200, but are directed again by the gas flow G2 to pass inside the edge of the wafer 200 and toward the exhaust hole 233.

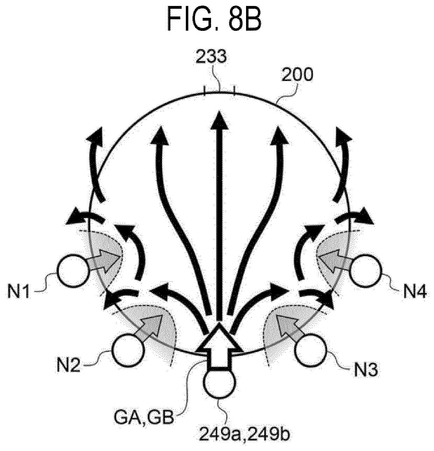

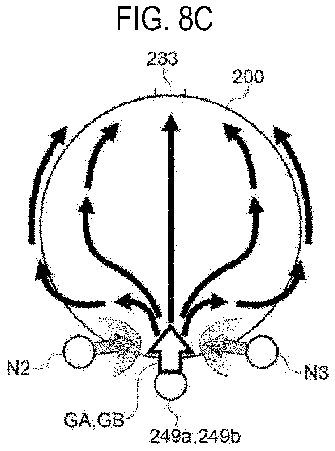

On the other hand, as Comparative Example 1, consider a case in which nozzles N1 to N4 are provided by two on each side at intervals from the gas supply holes 250a and 250b and an inert gas is ejected toward the center of the wafer 200. As shown in FIG. 8B, the gas flows GA and GB are pushed toward the inside of the wafer 200 by the gas flow G1, then toward the outer periphery of the wafer 200, and return to a peripheral edge of the wafer 200. This makes it easier for diffusion to occur from outside a peripheral edge of the dummy wafer 200 to the product region PD. In addition, as Comparative Example 2, as shown in FIG. 8C, consider a case in which the second ejection holes 250c2 and 250d2 are not provided. An inert gas flow G1 from the first ejection holes 250c1 and 250d1 mixes with the gas flows GA and GB. However, the gas flows GA and GB flow in a direction returning to an outer edge of the dummy wafer 200, making it easier for diffusion to occur from outside the peripheral edge of the dummy wafer 200 to the product region PD.

It is configured such that an inert gas ejected from the first ejection holes 250c1 and 250d1 corresponding to portions of the nozzles 249c and 249d where the second ejection holes 250c2 and 250d2 are not provided forms a vortex near the peripheral edge of the corresponding wafer 200. That is, the gas is blown out in the direction in which each of the gas supply holes 250a and 250b and the first ejection holes 250c1 and 250d1 is facing, and drawn in around thereof, thereby generating the vortex.

In addition, it is configured such that the inert gas ejected from the first ejection holes 250c1 and 250d1 corresponding to the portions of the nozzles 249c and 249d where the second ejection holes 250c2 and 250d2 are not provided is supplied at a flow rate equal to or greater than a predetermined flow rate so as to maintain in-plane uniformity (convexity) of a film formed on the corresponding wafer 200.

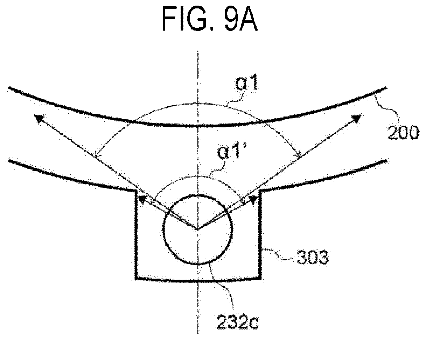

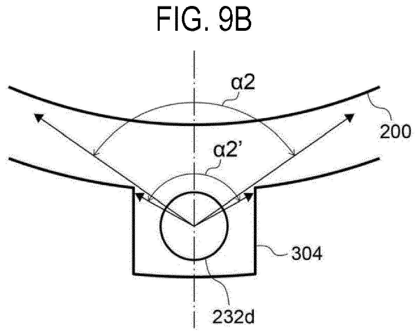

As shown in FIG. 9A, an angle α1 between ejection directions of the first ejection hole 250c1 and the second ejection hole 250c2 corresponds to an angle looking into both ends of an opening of the second protruding portion 303 from the center of the nozzle 249c. As shown in FIG. 9B, an angle α2 between ejection directions of the first ejection hole 250d1 and the second ejection hole 250d2 corresponds to an angle looking into both ends of an opening of the third protruding portion 304 from the center of the nozzle 249d. In addition, the angle α1 is an angle between a line connecting the center of the nozzle 249c and a center of the first ejection hole 250c1 and a line connecting the center of the nozzle 249c and a center of the second ejection hole 250c2. In addition, the angle α2 is an angle between a line connecting the center of the nozzle 249d and a center of the first ejection hole 250d1 and a line connecting the center of the nozzle 249d and a center of the second ejection hole 250d2.

An angle α1' in FIG. 9A represents an angle larger than the angle looking into the both ends of the opening of the second protruding portion 303 from the center of the nozzle 249c. An angle α2' in FIG. 9B represents an angle larger than the angle looking into both ends of the opening of the third protruding portion 304 from the center of the nozzle 249d.

It is preferable that the angle α1 between the ejection directions of the first ejection hole 250c1 and the second ejection hole 250c2 and the angle α2 between the ejection directions of the first ejection hole 250d1 and the second ejection hole 250d2 are 60 degrees or more and 120 degrees or less. If these angles are less than 60 degrees, a distance between the first ejection hole 250c1 and the second ejection hole 250c2 and a distance between the first ejection hole 250d1 and the second ejection hole 250d2 are close such that the edge of the wafer 200 may not be diluted over a wide range. If these angles exceed 120 degrees, the inert gas may hit walls of the second protruding portion 303 and the third protruding portion 304, making it impossible to dilute a wide range. In addition, most of the inert gas may flow into a gap between the wafer 200 and the reaction tube 203, so that the effect of dilution on the edge of the wafer 200 may be reduced.

A precursor gas (process gas) GA is supplied from the gas supply pipe 232a into the process chamber 201 via the MFC 241a, the valve 243a, and the nozzle 249a.

A gas GB, which is a process gas and acts as a reactant with a different chemical structure (molecular structure) from the above-mentioned precursor, is supplied from the gas supply pipe 232b into the process chamber 201 via the MFC 241b, the valve 243b, and the nozzle 249b.

An inert gas is supplied from the gas supply pipes 232c to 232f into the process chamber 201 via the MFCs 241c to 241f, the valves 243c to 243f, the gas supply pipes 232c, 232d, 232a, and 232b, and the nozzles 249c, 249d, 249a, and 249b, respectively. The inert gas acts as a purge gas and a carrier gas and also acts as a film thickness distribution control gas that controls the in-plane film thickness distribution of a film formed on the wafer 200.

A process gas supply system mainly includes the gas supply pipes 232a and 232b, the MFCs 241a and 241b, and the valves 243a and 243b. In addition, an inert gas supply system mainly includes the gas supply pipes 232c to 232f, the MFCs 241c to 241f, and the valves 243c to 243f.

The exhaust hole 233 as an exhauster for exhausting the atmosphere of the process chamber 201 is provided in the reaction tube 203. As shown in a horizontal cross-sectional view of FIG. 2, the exhaust hole 233 is provided at a position facing (opposing) the nozzles 249a and 249b (the gas supply holes 250a and 250b) with the wafers 200 interposed therebetween. An exhaust pipe 231 is connected to the exhaust hole 233. The exhaust pipe 231 is provided with a pressure sensor 245 as a pressure detector for detecting a pressure of the process chamber 201 and is connected to a vacuum pump (vacuum exhauster) 246 via an auto pressure controller (APC) valve 244 as a pressure regulator. The APC valve 244 is configured to perform or stop vacuum exhaust in the process chamber 201 by opening or closing the valve while the vacuum pump 246 is actuated. The APC valve 244 is also configured to regulate the pressure of the process chamber 201 by adjusting an opening degree of the valve based on pressure information detected by the pressure sensor 245 while the vacuum pump 246 is actuated. An exhaust system mainly includes the exhaust pipe 231, the APC valve 244, and the pressure sensor 245. The exhaust system may also include the vacuum pump 246.

A seal cap 219, which serves as a lid that is capable of hermetically sealing an opening at a lower end of the manifold 209, is provided below the manifold 209. The lid 219 is made of, for example, metal and is formed in a disc shape. An O-ring 220b, which is a seal making contact with the lower end of the manifold 209, is provided on an upper surface of the lid 219. A rotator 267 that rotates a boat 217, which is described later, is provided below the lid 219. A rotary shaft 255 of the rotator 267 is connected to the boat 217 through the lid 219. The rotator 267 rotates the wafers 200 by rotating the boat 217.

The lid 219 is configured to be vertically moved up and down by a boat elevator 115 as an elevator installed outside the reaction tube 203. The elevator 115 is configured as a transfer apparatus (transfer mechanism) which loads/unloads (transfers) the wafers 200 into/out of the process chamber 201 by moving the lid 219 up and down. In addition, a shutter 221, which serves as a furnace opening lid that is capable of hermetically sealing the opening at the lower end of the manifold 209 while the lid 219 is lowered and the boat 217 is completely unloaded from the process chamber 201, is provided below or to a side of the manifold 209. The shutter 221 is formed in a disc shape like the lid 219. An O-ring 220c, which makes contact with the lower end of the manifold 209, is provided on an upper surface of the shutter 221. The opening/closing operation (such as elevation operation, rotation operation, or the like) of the shutter 221 is controlled by a shutter opening/closing mechanism 222.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. At a lower portion of the boat 217, heat insulating plates 218 made of, for example, a heat resistant material such as quartz or SiC are supported in multiple stages.

A temperature sensor 263 serving as a temperature detector is installed in the reaction tube 203. Based on temperature information detected by the temperature sensor 263, a state of supplying electric power to the heater 207 is regulated such that a temperature of the process chamber 201 achieves a desired temperature distribution. The temperature sensor 263 is installed along the inner wall of the reaction tube 203.

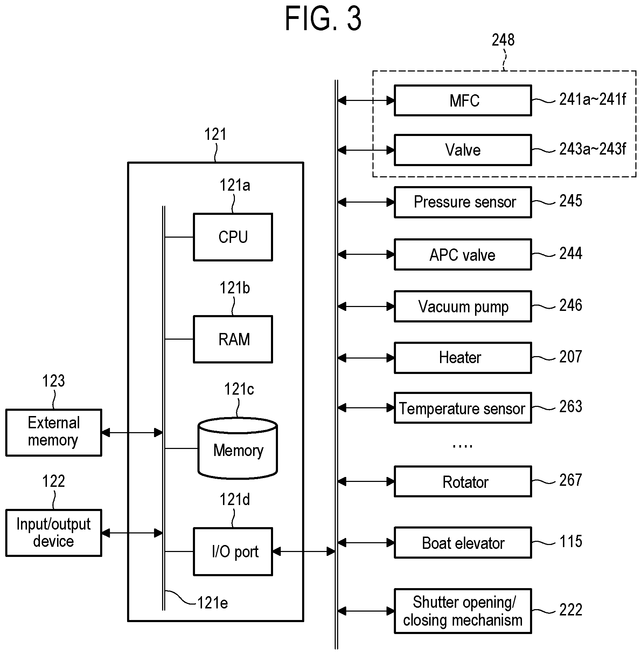

As shown in FIG. 3, a controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 formed of, e.g., a touch panel or the like, is connected to the controller 121.

The memory 121c is configured by, for example, a flash memory, a hard disk drive (HDD), or the like. A control program for controlling operations of the substrate processing apparatus, a process recipe in which procedures, conditions, etc. of substrate processing to be described later are written, etc. are readably stored in the memory 121c. The process recipe functions as a program that is combined to cause the controller 121 to execute each procedure in the substrate processing, which is described later, to obtain a predetermined result. Hereinafter, the process recipe and the control program may be collectively and simply referred to as a "program." Furthermore, the process recipe may be simply referred to as a "recipe." When the term "program" is used herein, it may refer to a case of including the recipe, a case of including the control program, or a case of including both the recipe and the control program. The RAM 121b is configured as a memory area (work area) in which programs, data, and the like read by the CPU 121a are temporarily stored.

The I/O port 121d is connected to the MFCs 241a to 241f, the valves 243a to 243f, the pressure sensor 245, the APC valve 244, the vacuum pump 246, the temperature sensor 263, the heater 207, the rotator 267, the elevator 115, the shutter opening/closing mechanism 222, and so on.

The CPU 121a is configured to read and execute the control program from the memory 121c. The CPU 121a is also configured to read the recipe from the memory 121c according to an input of an operation command and the like from the input/output device 122. The CPU 121a is configured to, according to contents of the recipe thus read, control the flow rate regulating operations of various kinds of gases by the MFCs 241a to 241f, the opening/closing operations of the valves 243a to 243f, the opening/closing operation of the APC valve 244, the pressure regulating operation performed by the APC valve 244 based on the pressure sensor 245, the startup and shutdown operation of the vacuum pump 246, the temperature regulating operation performed by the heater 207 based on the temperature sensor 263, the operation of rotating the boat 217 with the rotator 267 and adjusting the rotation speed of the boat 217, the operation of moving the boat 217 up and down by the elevator 115, the opening/closing operation of the shutter 221 by the shutter opening/closing mechanism 222, and so on.

The controller 121 may be configured by installing, on the computer, the aforementioned program stored in an external memory 123. Examples of the external memory 123 may include a magnetic disk such as a hard disk, an optical disc such as a CD, a magneto-optical disc such as a MO, a semiconductor memory such as a USB memory, and the like. The memory 121c or the external memory 123 is configured as a non-transitory computer-readable recording medium. Hereinafter, the memory 121c and the external memory 123 may be collectively and simply referred to as a "recording medium." When the term "recording medium" is used herein, it may indicate a case of including the memory 121c, a case of including the external memory 123, or a case of including both the memory 121c and the external memory 123. Furthermore, the program may be provided to the computer by using communication means such as the Internet or a dedicated line, instead of using the external memory 123.

### (2) Film-Forming Process

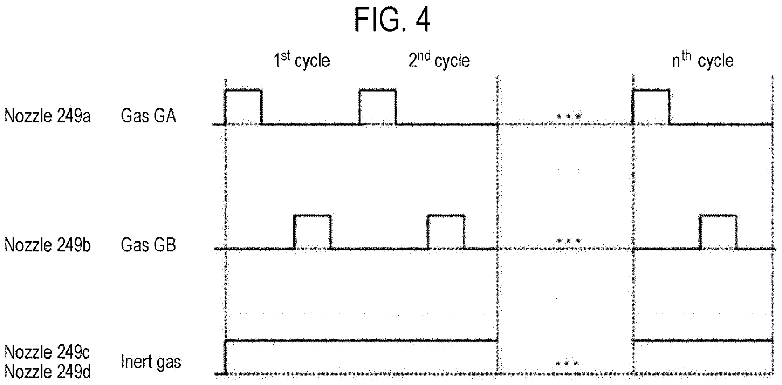

As a process of manufacturing a semiconductor device by using the above-described substrate processing apparatus, an example of a sequence for forming a film (referred to as an AB film) on a wafer 200 as a substrate is described with reference to FIG. 4. In the following description, the operations of the respective components constituting the substrate processing apparatus are controlled by the controller 121.

A film-forming sequence shown in FIG. 4 includes forming a film containing A and B (herein, referred to as an AB film), i.e., an AB film, on a wafer 200 by performing a cycle n times (n is a predetermined number that is an integer of 1 or more), the cycle including non-simultaneously performing step A of forming a first layer by supplying the gas GA, which is a process gas, to the wafer 200 from the nozzle 249a, and a step B of forming an AB layer, which is a second layer, by supplying the gas GB, which is a process gas, to the wafer 200 from the nozzle 249b.

When the term "wafer" is used in the present disclosure, it may refer to "a wafer itself" or "a stacked body including a wafer and a predetermined layer or film formed on a surface of the wafer." When the term "a surface of a wafer" is used in the present disclosure, it may refer to "a surface of a wafer itself" or "a surface of a predetermined layer formed on a wafer." When the term "substrate" is used in the present disclosure, it may be synonymous with the term "wafer. "

### (Wafer Charging and Boat Loading)

After the boat 217 is charged with a plurality of wafers 200 (wafer charging), the shutter 221 is moved by the shutter opening/closing mechanism 222 and the opening at the lower end of the manifold 209 is opened. Thereafter, as shown in FIG. 1, the boat 217 supporting the plurality of wafers 200 is lifted up by the elevator 115 to be loaded into the process chamber 201 (boat loading). In this state, the lid 219 seals the lower end of the manifold 209 through the O-ring 220b.

### (Pressure Regulation and Temperature Regulation)

An interior of the process chamber 201, that is, a space where the wafers 200 are placed, is vacuum-exhausted by the vacuum pump 246 to reach a desired pressure. At this time, the pressure of the process chamber 201 is measured by the pressure sensor 245, and the APC valve 244 is feedback-controlled based on the measured pressure information. Further, the wafers 200 in the process chamber 201 are heated by the heater 207 so as to achieve a desired film formation temperature. At this time, a state of supplying electric power to the heater 207 is feedback-controlled based on the temperature information detected by the temperature sensor 263 so that the interior of the process chamber 201 achieves a desired temperature distribution. Further, the rotation of the wafers 200 by the rotator 267 is started. The exhaust of the interior of the process chamber 201 and the heating and rotation of the wafers 200 are continuously performed at least until the processing on the wafers 200 is completed.

### (Film-Forming Step)

Thereafter, the following steps A and B are performed sequentially.

### [Step A]

In this step, the gas GA is supplied to the wafer 200 in the process chamber 201.

Specifically, the valve 243a is opened to allow the gas GA to flow into the gas supply pipe 232a. A flow rate of the gas GA is regulated by the MFC 241a, and the gas GA is supplied into the process chamber 201 via the nozzle 249a and is then exhausted through the exhaust hole 233. That is, the gas GA is supplied to the wafer 200. At this time, the valve 243e may be opened to allow an inert gas to flow into the gas supply pipe 232e. A flow rate of the inert gas is regulated by the MFC 241e, and the inert gas is, together with the gas GA, supplied into the process chamber 201 via the nozzle 249a and is then exhausted through the exhaust hole 233. Also in step A, the inert gas is respectively supplied into the process chamber 201 via the nozzles 249c and 249d while the gas GA is being supplied into the process chamber 201 via the nozzle 249a. The details thereof is described later.

In step A, a flow rate of the inert gas ejected from portions of the first ejection holes 250c1 and 250d1 to which no corresponding second ejection holes 250c2 and 250d2 are provided is regulated so that a vortex is formed on the periphery of the corresponding wafer 200. The action of this vortex improves in-plane uniformity of a film formed on the wafer 200.

For example, if the flow rate of the inert gas supplied from the first ejection holes 250c1 and 250d1 is too small relative to that of the gas GA, the inert gas supplied from the first ejection holes 250c1 and 250d1 may be overwhelmed by the gas GA. That is, a precursor gas flowing through a gap G region flows downstream without being diluted, and a total amount of the precursor gas reaching the center of the wafer 200 is reduced. In other words, a film thickness distribution of the film formed on the wafer 200 may become concave, which may result in poor in-plane film thickness uniformity.

In addition, if the flow rate of the inert gas supplied from the first ejection holes 250c1 and 250d1 is too large relative to that of the gas GA, a dilution effect of the inert gas supplied from the first ejection holes 250c1 and 250d1 on the precursor gas flowing through the gap G region becomes large, and the total amount of precursor gas reaching the center of the wafer may become too large. In other words, the film thickness distribution of the film formed on the wafer 200 may become convex, which may result in poor in-plane film thickness uniformity.

These flow rate conditions vary depending on a surface area of the wafer 200, a wafer pitch, a width of the gap G between the reaction tube 203 and the wafer 200, positions of the nozzles 249c and 249d, directions of the first ejection holes 250c1 and 250d1 of the nozzles 249c and 249d, gas types, a film formation temperature, a processing pressure, etc.

Herein, the gas GA is consumed less in the dummy region DM than in the product region PD, and in the product region PD near a boundary with the dummy region DM, an excess gas in the dummy region DM may diffuse into the product region PD. Specifically, in the vicinity of the dummy region DM, a thickness of a film formed on the wafer 200 in the product region PD may be thicker than that of the wafer 200 in the other part of the product region PD. In this embodiment, as shown in FIGS. 7A to 8A, the inert gas G1 from the first ejection holes 250c1 and 250d1 mixes with the gases GA and GB at a peripheral edge BA of the dummy wafer 200 in the dummy region DM. Then, the gases GA and GB flow in a direction returning to the outer edge of the dummy wafer 200 and mix with the inert gas G2 from the second ejection holes 250c2 and 250d2 at a peripheral edge BB. Then, the gases GA and GB are guided toward the exhaust hole 233. Therefore, the gases GA and GB are prevented from diffusing from the peripheral edge of the dummy wafer 200 to the product region PD.

In step A, while the gas GA is being supplied from the nozzle 249a, the valves 243c, 243d, 243f are opened to allow an inert gas to flow into the gas supply pipes 232c, 232d, and 232b, and the inert gas is supplied into the process chamber 201 from the nozzles 249c, 249d, and 249b. It is not needed to maintain a small amount of inert gas supply from the nozzle 249b, but this is preferable from the viewpoint of preventing intrusion of the gas GA into the nozzle 249b. To achieve the above, it is preferable to start the supply of the inert gas from the nozzle 249b simultaneously with or before step A.

As described above, by supplying the gas GA and the inert gas to the wafer 200, the first layer is formed on an outermost surface of the wafer 200.

After the first layer is formed, the valve 243a is closed to stop the supply of the gas GA. At this time, with the APC valve 244 left open, the process chamber 201 is vacuum-exhausted by the vacuum pump 246 to remove the gas GA which remains in the process chamber 201 after contributing to the formation of the first layer or did not react from the process chamber 201. The inert gas supplied from the nozzles 249a to 249d acts as a purge gas, thereby purging the process chamber 201 (purging step).

### [Step B]

After step A is completed, the gas GB is supplied to the wafer 200 in the process chamber 201, i.e., to the first layer formed on the wafer 200.

In this step, the opening/closing control of the valves 243b and 243c to 243f is performed in the same order as the opening/closing control of the valves 243a and 243c to 243f in step A. A flow rate of the gas GB is regulated by the MFC 241b, and the gas GB is supplied into the process chamber 201 via the nozzle 249b and is exhausted through the exhaust hole 233. At this time, the gas GB is supplied to the wafer 200.

In step B, the flow rate of the inert gas ejected from the portions of the first ejection holes 250c1 and 250d1 to which no corresponding second ejection holes 250c2 and 250d2 are provided is regulated so that a vortex is formed on the periphery of the corresponding wafer 200. By setting in this manner, the same effects as those described in the above-described step A may be obtained.

In step B, as in the gas GA, the gas GB is prevented from diffusing from the dummy region DM to the product region PD by the inert gas from the nozzles 249c and 249d.

When the gas GB and the inert gas are supplied to the wafer 200 in this manner, at least a portion of the first layer formed on the wafer 200 is modified. As a result, the second layer is formed on the wafer 200.

After the second layer is formed, the valve 243b is closed to stop the supply of the gas GB. Then, the gas GB which remains in the process chamber 201 after contributing to the formation of the second layer or did not react, and reaction by-products are removed from the process chamber 201 according to the same processing procedures and process conditions as the purging step of step A.

### [Performing Predetermined Number of Times]

By performing the cycle one or more times (n times), the cycle including non-simultaneously, that is, without synchronization, performing steps A and B, the AB film with a predetermined composition and a predetermined thickness may be formed on the wafer 200. It is desirable to repeat the above cycle a plurality of times. That is, a thickness of the second layer formed per cycle may be set to be smaller than a desired film thickness, and the above cycle may be repeated a plurality of times until a thickness of the AB film formed by stacking second layers reaches the desired film thickness.

### (After-Purge and Atmospheric Pressure Recovery)

When the film with the desired composition and thickness is formed on the wafer 200, an inert gas as a purge gas is supplied into the process chamber 201 from each of the nozzles 249a to 249d and is exhausted through the exhaust hole 233. Thus, the interior of the process chamber 201 is purged to remove any gases and reaction by-products remaining in the process chamber 201 from the process chamber 201 (after-purge). Thereafter, the atmosphere of the process chamber 201 is substituted with the inert gas, and the pressure of the process chamber 201 is returned to the normal pressure (atmospheric pressure recovery).

### (Boat Unloading and Wafer Discharging)

The lid 219 is moved down by the elevator 115 to open the lower end of the manifold 209. Then, the processed wafers 200 supported by the boat 217 are unloaded from the lower end of the manifold 209 to an outside of the reaction tube 203 (boat unloading). Afterwards, the shutter 221 is moved and the opening at the lower end of the manifold 209 is sealed by the shutter 221 via the O-ring 220c. The processed wafers 200 are unloaded to the outside of the reaction tube 203 and are then discharged from the boat 217 (wafer discharging).

### (3) Effects of the Present Embodiments

According to the present embodiments, one or more effects set forth below may be achieved.

(a) The substrate processing apparatus according to the present embodiments include the plurality of first ejection holes 250c1 and 250d1 that correspond to each of the plurality of wafers 200 and are opened toward the upstream of the gas flow flowing from the nozzles 249a and 249b toward the exhaust hole 233 and one or more second ejection holes 250c2 and 250d2 that correspond to some of the plurality of wafers 200 and are opened toward the downstream of the gas flow from the nozzles 249a and 249b toward the exhaust hole 233. Then, the inert gas supplied from at least one selected from the group of the first ejection holes 250c1 and 250d1 and the second ejection holes 250c2 and 250d2 and the process gas from the nozzles 249a and 249b mix with each other at the peripheral edges of the plurality of wafers 200. Therefore, the gas flow on some of the wafers 200 may be made smooth, and unintended diffusion of the process gas from the dummy region DM corresponding to some of the plurality of wafers 200 may be suppressed.

(b) By providing the second ejection holes 250c2 and 250d2 corresponding to one or more wafers 200 disposed on the uppermost side of the plurality of wafers 200 and one or more wafers 200 disposed on the lowermost side thereof, unintended diffusion of the process gas in other regions where the second ejection holes 250c2 and 250d2 are not provided may be suppressed.

(c) The inert gas supplied from the first ejection holes 250c1 and 250d1 and the second ejection holes 250c2 and 250d2 respectively mixes with the process gas at the peripheral edges of the plurality of wafers 200. Therefore, since the gas flow over the plurality of wafers 200 may be made smooth, the occurrence of diffusion of the process gas from the plurality of wafers 200 may be suppressed.

(d) The inert gas ejected from the first ejection holes 250c1 and 250d1 that do not have the corresponding second ejection holes 250c2 and 250d2 forms a vortex near the peripheral edges of the corresponding wafers 200. Therefore, the flow rate of the process gas on the periphery of the wafers 200 may be regulated by the inert gas supplied from the first ejection holes 250c1 and 250d1, so that the in-plane uniformity of the film formed on the corresponding wafer 200 may be improved.

(e) In the reaction tube 203, the first protruding portion 302 is formed to accommodate the nozzles 249a and 249b, the second protruding portion 303 is formed to accommodate the nozzle 249c, and the third protruding portion 304 is formed to accommodate the nozzle 249d. Therefore, the influence of each nozzle on the substrate processing may be suppressed.

(f) The second ejection holes 250c2 and 250c2 are provided to correspond to the dummy wafers 200 that are disposed at the boundary with the product region PD among the plurality of wafers 200. Therefore, the diffusion of the process gas from the dummy region DM in which the dummy wafers 200 are placed to the product region PD in which the product wafers 200 are placed may be suppressed by the action of the second ejection holes 250c2 and 250c2.

(g) By regulating installation positions of the nozzles 249c and 249d, directions of the first ejection holes 250c1 and 250d1 and the second ejection holes 250c2 and 250d2 formed on the nozzles 249c and 249d, etc., the gas flow on some of the plurality of wafers 200 may be made smooth, and unintended diffusion of the process gas from the dummy region DM corresponding to some of the plurality of wafers 200 may be suppressed.

Embodiments of the present disclosure are specifically described above. However, the present disclosure is not limited to the above-described embodiments, and various modifications may be made without departing from the gist of the present disclosure.

In the above-described embodiments, an example is described in which two counter nozzles, the nozzle 249c and the nozzle 249d, are used, but the present disclosure is not limited thereto, and the number of counter nozzles may be one or three or more. Note that, if there is one counter nozzle, the peripheral edge of the wafer on the side where there is no counter nozzle is thickened, and thus two or more counter nozzles are preferable.

In addition, the above-described embodiments may be suitably applied to film-forming processes including, for example, CVD (Chemical Vapor Deposition), PVD (Physical Vapor Deposition), a process of forming an oxide film and a nitride film, and a process of forming a film containing metal.

In addition, recipes used in the substrate processing may be prepared individually according to processing contents and may be stored in the memory 121c via an electrical communication line or the external memory 123. Moreover, at the beginning of the processing, the CPU 121a may properly select an appropriate recipe from the recipes stored in the memory 121c according to the contents of the substrate processing. Thus, it is possible for a single substrate processing apparatus to form films of various types, composition ratios, qualities, and thicknesses with enhanced reproducibility. Further, it is possible to reduce an operator's burden and to quickly start the processing while avoiding an operation error.

In addition, the above-mentioned recipes are not limited to newly-prepared ones but may be prepared, for example, by modifying existing recipes that are already installed in the substrate processing apparatus. When modifying the recipes, the modified recipes may be installed in the substrate processing apparatus via an electrical communication line or a recording medium recording the recipes. In addition, the existing recipes already installed in the existing substrate processing apparatus may be directly modified by operating the input/output device 122 of the substrate processing apparatus.

Further, the present disclosure may be applied to a semiconductor manufacturing apparatus that processes a semiconductor wafer, such as the above-described substrate processing apparatus, as well as to a LCD (Liquid Crystal Display) manufacturing apparatus that processes a glass substrate.

According to the present disclosure in some embodiments, it is possible to supply a process gas evenly onto a substrate.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A substrate processing apparatus comprising:
a process chamber (201) including an exhaust hole (233) facing a side of a plurality of accommodated substrates (200);
a first nozzle (249a, 249b) installed at a position facing the exhaust hole (233) and configured to supply a process gas for processing the plurality of substrates (200) into the process chamber (201); and
a second nozzle (249c, 249d) configured to supply an inert gas into the process chamber (201), and formed with a plurality of first ejection holes (250c1, 250d1) that correspond to each of the plurality of substrates (200) and are opened toward an upstream of a gas flow flowing from the first nozzle (249a, 249b) to the exhaust hole (233) and one or more second ejection holes (250c2, 250d2) that correspond to some of the plurality of substrates (200) and are opened toward a downstream of the gas flow flowing from the first nozzle (249a, 249b) to the exhaust hole (233),
wherein the first nozzle (249a, 249b) and the second nozzle (249c, 249d) are configured to mix the inert gas, which is supplied from at least one selected from the group of the plurality of first ejection holes (250c1, 250d1) and the one or more second ejection holes (250c2, 250d2), and the process gas at peripheral edges of the plurality of substrates (200).

2. The substrate processing apparatus of Claim 1, wherein the plurality of first ejection holes (250c1, 250d1) are opened toward the first nozzle (249a, 249b).

3. The substrate processing apparatus of Claim 1, wherein the one or more second ejection holes (250c2, 250d2) are opened toward the exhaust hole (233).

4. The substrate processing apparatus of Claim 1, wherein the one or more second ejection holes (250c2, 250d2) are provided to correspond to one or more substrates (200) disposed at an uppermost side among the plurality of substrates (200) and one or more substrates (200) disposed at a lowermost side among the plurality of substrates (200).

5. The substrate processing apparatus of Claim 1, wherein the plurality of first ejection holes (250c1, 250d1) and the one or more second ejection holes (250c2, 250d2) are configured to be provided to correspond to a same substrate (200) in an arrangement direction of the plurality of substrates (200).

6. The substrate processing apparatus of Claim 5, wherein the plurality of first ejection holes (250c1, 250d1) and the one or more second ejection holes (250c2, 250d2) are configured to be positioned at a same position in the arrangement direction of the plurality of substrates (200).

7. The substrate processing apparatus of Claim 1, wherein the inert gas ejected from the first ejection holes (250c1, 250d1) to which the one or more second ejection holes (250c2, 250d2) are not provided at corresponding positions on the second nozzle (249c, 249d) in an arrangement direction of the plurality of substrates (200) is configured such that the inert gas is supplied at a flow rate equal to or greater than a predetermined flow rate so as not to change in-plane uniformity of a film formed on corresponding substrates (200).

8. The substrate processing apparatus of Claim 1, wherein the second nozzle (249c, 249d) is disposed at a position where an angle between a line connecting the first nozzle (249a, 249b) and a center of the plurality of substrates (200) and a line connecting the second nozzle (249c, 249d) and the center of the plurality of substrates (200) is 120 degrees or less.

9. The substrate processing apparatus of Claim 1, wherein the process chamber (201) includes a cylindrical inner tube, and the inner tube includes a first nozzle chamber (302) and a second nozzle chamber (303) that protrude outward and accommodate the first nozzle (249a, 249b) and the second nozzle (249c, 249d), respectively, inside the inner tube.

10. The substrate processing apparatus of Claim 9, wherein an angle between ejection directions of the plurality of first ejection holes (250c1, 250d1) and the one or more second ejection holes (250c2, 250d2) corresponds to an angle looking into both ends of an opening of the second nozzle chamber (303) from a center of the second nozzle (249c, 249d).

11. The substrate processing apparatus of Claim 10, wherein the angle between the ejection directions of the plurality of first ejection holes (250c1, 250d1) and the one or more second ejection holes (250c2, 250d2) provided for corresponding substrates (200) is 60 degrees or more and 120 degrees or less.

12. The substrate processing apparatus of Claim 1, wherein the one or more second ejection holes (250c2, 250d2) are provided to correspond to dummy substrates (200) among the plurality of substrates (200).

13. The substrate processing apparatus of Claim 12, wherein the process gas and the inert gas are configured to mix with each other at a plurality of peripheral edges of the dummy substrates (200).

14. The substrate processing apparatus of Claim 12, wherein the one or more second ejection holes (250c2, 250d2) are provided to correspond to the dummy substrates (200) disposed to sandwich product substrates (200) among the plurality of substrates (200) in an arrangement direction of the plurality of substrates (200).

15. A method of manufacturing a semiconductor device, comprising:
preparing a substrate processing apparatus including:
a process chamber (201) including an exhaust hole (233) facing a side of a plurality of accommodated substrates (200);
a first nozzle (249a, 249b) installed at a position facing the exhaust hole (233) and configured to supply a process gas for processing the plurality of substrates (200) into the process chamber (201);
a second nozzle (249c, 249d) configured to supply an inert gas into the process chamber (201), and formed with a plurality of first ejection holes (250c1, 250d1) that correspond to each of the plurality of substrates (200) and are opened toward an upstream of a gas flow flowing from the first nozzle (249a, 249b) to the exhaust hole (233) and one or more second ejection holes (250c2, 250d2) that correspond to some of the plurality of substrates (200) and are opened toward a downstream of the gas flow flowing from the first nozzle (249a, 249b) to the exhaust hole (233); and
mixing the inert gas, which is supplied from at least one selected from the group of the plurality of first ejection holes (250c1, 250d1) and the one or more second ejection holes (250c2, 250d2), and the process gas at peripheral edges of the plurality of substrates (200).
